Europäisches Patentamt

European Patent Office

Office européen des brevets

(19)

(11) Publication number: **0 072 861**
**B1**

# (12) EUROPEAN PATENT SPECIFICATION

(45) Date of publication of patent specification: **04.11.87**

(51) Int. Cl.⁴: **B 05 D 7/22**, C 23 C 10/00

(21) Application number: **82901077.6**

(22) Date of filing: **23.02.82**

(86) International application number:
**PCT/US82/00220**

(87) International publication number:
**WO 82/03027 16.09.82 Gazette 82/22**

## (54) DIFFUSION COATING AND PRODUCTS.

(30) Priority: **26.02.81 US 238500**

(43) Date of publication of application:
**02.03.83 Bulletin 83/09**

(45) Publication of the grant of the patent:
**04.11.87 Bulletin 87/45**

(84) Designated Contracting States:
**DE FR GB SE**

(56) References cited:
**FR-A-1 031 167**
**FR-A-1 049 330**
**FR-A-1 237 713**
**GB-A- 727 567**
**GB-A- 798 853**
**US-A- 711 164**
**US-A-2 851 375**
**US-A-3 108 013**
**US-A-3 936 539**
**US-A-4 041 196**
**US-A-4 197 336**
**US-A-4 208 453**
**US-A-4 290 391**

(73) Proprietor: **ALLOY SURFACES COMPANY, INC.**
**100 Locke Road Edgemoor**
**Wilmington Delaware 19809 (US)**

(72) Inventor: **BALDI, Alfonso L.**
**415 East Lancaster Avenue C-5**
**Wynnewood, PA 19096 (US)**

(74) Representative: **Bizley, Richard Edward et al**
**BOULT, WADE & TENNANT 27 Furnival Street**
**London EC4A 1PQ (GB)**

(56) References cited:
**CHEMICAL ABSTRACTS, vol. 96, no. 12, March 1982, page 250, abstract no. 89372a, COLUMBUS OHIO (US), M. BOMERSKI: "Heat-resistant chromium-titanium-aluminium diffusion coatings on carbon steels"**

**METAL SCIENCE AND HEAT TREATMENT, vol. 17, no. 7/8, July/August 1975, Plenum Publishing Corp., I. GOGACHEV et al.: "Multicomponent diffusion saturation of low-carbon steels in gaseous media", pages 659-661**

Courier Press, Leamington Spa, England.

## Description

The present invention relates to the coating of metals to increase their resistance to corrosion and other chemical attacks.

For increasing the resistance of steels, even low alloy steels, to attack by hot sulfur-containing materials, chromizing is very effective when it penetrates more than about 3 mils (76.2 um) and is followed by an even deeper aluminizing. Less penetrating treatment of superalloys is disclosed in U.S. Patents 3,764,371, 3,694,255 and 4,041,196, and a similar treatment is disclosed in U.S. Patent 3,656,919, but the present invention applies such a sequence to low alloy steels such as those called chromium steels. These chromium steels of the present invention contain from about 0.6 to about 1.5% chromium, and their carbon contents can range from about 0.15% to about 1.10%. This carbon content is not in stabilized form and is accordingly sufficient to seriously limit the case depth obtained by chromizing, as well as correspondingly limit the maximum resistance obtainable against hot sulfidation. Unprotected low alloy steels used in petroleum refinery operations for example, are generally very susceptible to hot sulfidation, so that a high degree of protection is called for.

According to the present invention there is provided a process for increasing the resistance to hot sulfidation of a low alloy steel member, which process is characterised by:

(a) if the steel contains about 0.1% or more of carbon which has not been stabilised, decarburising to a depth of substantially 3 mils (76.2 um) or more the surface of the member exposed to the attack,

(b) diffusion chromizing said surface to produce a chromized case substantially 2 mils (50.8 um) or more thick, the inner portion of which has a columnar ferrite structure, and

(c) diffusion aluminizing the chromized case to provide a final diffusion case substantially 10 mils (254 um) or more thick and thicker than the chromized case.

According to the present invention, there is also provided a low alloy steel member having a surface portion decarburized, if the steel contains about 0.1% or more of carbon which has not been stabilised, to a depth of substantially 3 mils (76.2 μm) or more, chromized to a depth of substantially 2 mils (50.8 μm) or more to form a chromized case whose inner portion has a columnar ferrite structure and then aluminized to a depth of at least 10 mils (254 μm) and greater than the chromized depth.

The respective treatments can be applied individually in spaced operations, or they can be combined as successive stages of a single heat sequence. Each stage can be a conventional one such as:

## Example I

1. A number of chromium steel tubes used for a heat exchanger in the oxidative cracking of sulfur-containing petroleum residues were cleaned, and then placed in a retort through which hydrogen having a dew point of 40 to 60°F (4.5—16°C) is passed, while the retort is heated to 1800—1850°F (982—1010°C) for three hours. Before the treatment, the tubes had 0.7 to 0.8% chromium and 0.18% carbon, their side walls were about 1/4 inch (6.4 mm) thick, their internal diameter about 2 inches (5.08 cm), and one end of each tube was flared out and mushroomed back. After the three hour treatment, heating was discontinued and the tubes permitted to cool to room temperature. They showed a surface decarburization about 6 mils (152 μm) deep.

2. The decarburized tubes were then loaded in a vertical retort, the floor of which had a four-inch (100.2 cm) thick layer of powdered chromizing pack into which the flared ends were embedded. The interior of the tubes were filled with the same chromizing pack, which was a pre-fired 1:4 by weight mixture of chromium powder and the fluent tabular $Al_2O_3$ described in U.S. Patent 4,208,453, with 1/2% $NH_4Cl$ based on the weight of the 1:4 mixture. The retort was then covered and fired as in U.S. Patent 3,801,357 to bring its contents to 1950—1975°F (1066—1079°C) for ten hours. Upon subsequent cool-down the tubes showed a chromized case 3 to 4 mils (76.2—102 μm) thick, the outer quarter having a chromium-carbide-rich phase with the remainder having a columnar ferrite structure.

3. The chromized tubes were returned to the vertical retort, which this time contained a layer of aluminizing powder pack, and the tube interiors were filled with the same aluminizing pack—a pre-fired mixture of 45 weight % chromium powder, 10 weight % aluminum powder and 45 weight % powdered alumina, activated with 1/2% $NH_4Cl$. The aluminizing heat was at 1950—1975°F (1066—1079°C) for ten hours and left a consolidated diffusion case 12 to 14 mils (305—356 μm) thick. The outer surface of this case contained about 21% aluminum and about 21% chromium, whereas the middle of the case contained about 12.5% aluminum and about 13.7% chromium. These tubes showed a very high resistance against hot sulfidation, and in one instance a tube was attacked so severely that the steel base was completely eaten through leaving an almost unscathed diffusion case as a shell.

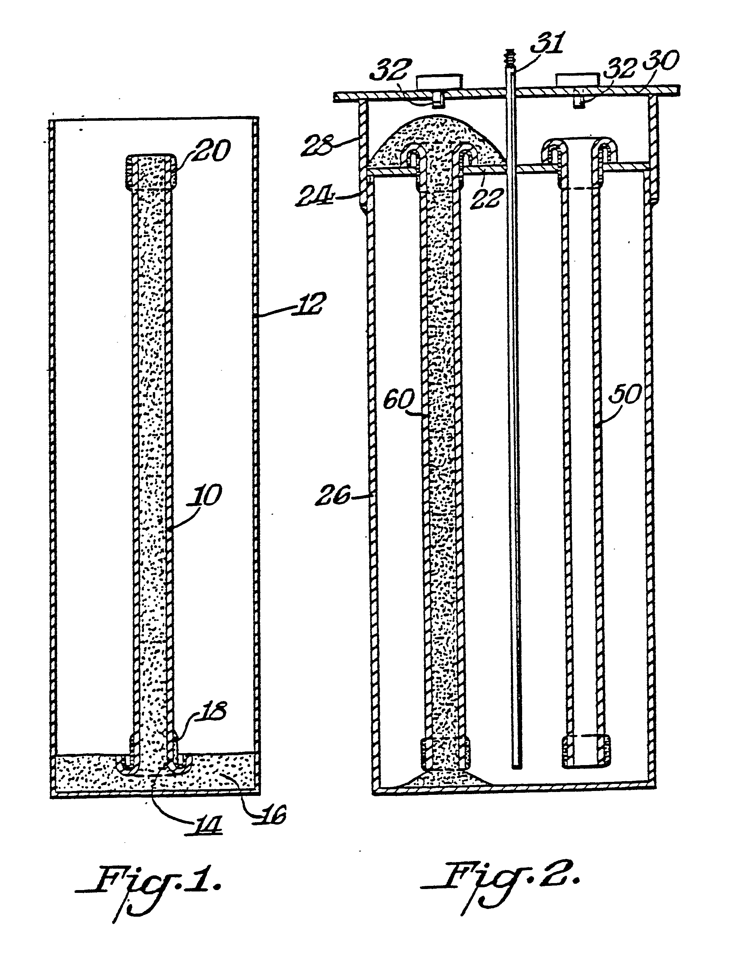

A typical tube of the foregoing type is illustrated at 10 in Fig. 1, where it is shown held in a retort 12 with its reversely flared end 14 imbedded in one of the diffusion coating packs. Where the tube has an external surface portion that is not to receive a diffusion coating, as for instance because that portion is closely fitted into a mounting sheet or the like, that surface portion can be masked. Thus a slurry type powdered alumina masking coating can be applied as illustrated at 18 and 20. Alternatively a powder type masking mixture can be poured into the cup-shaped portion of flare 14, and if desired such powder can be held in place with the help of a steel ring fitted around the powder and resting on the upturned lip of the flare.

The decarburizing can be conducted in any convenient way, although it is preferred to use hydrogen having a dew point at least as high as 0°F (−18°C). The decarburizing temperature can vary in the manner shown in the prior art, and effective decarburizing produces a weight loss of from about 0.3 to about 0.6 milligrams per square centimeter of treated surface. This can be checked by including in the retort a spare coupon of the metal being treated and withdrawing the coupon to check its weight.

The diffusion chromizing and aluminizing can also be varied as disclosed in the prior art. A good chromium pick-up is at least 15 and better still over 25 milligrams per square centimeter of surface, and a good aluminum pick-up is at least 25 and preferably over 40 milligrams per square centimeter. Another good combination has a pick-up of over 30 milligrams of chromium per square centimeter and a pick-up of about 20 to about 40 milligrams per square centimeter of aluminum.

Although the aluminum pick-up appears large when measured in milligrams per square centimeter, the aluminum penetration is so deep and aggressive that the aluminum concentration at the surface can be as little as 5% by weight. The aluminizing also causes the chromium diffusion to deepen, but the final concentration of chromium of the surface is generally at least about 15%.

The separate treatments can be partially or completely run together in a single retort without removing the tubes from the retort between treatment steps. Some combinations of decarburizing with chromizing are mentioned in U.S. Patent 3,449,159, but the decarburizing of the present invention is a very substantial one in which the decarburized zone is not only deep but shows a carbon content well below 0.05%.

Gas chromizing as in U.S. Patent 3,449,159 and 3,222,122 is particularly desirable when consolidating the chromizing with both the decarburizing and the aluminizing. The only pack in contact with the tubes in such a consolidation is the aluminizing pack, inasmuch as gas aluminizing is not sufficiently effective.

Fig. 2 illustrates a retorting arrangement for consolidated treatments. Two tubes 50 and 60 are here shown lowered through a perforated removable shelf 22 resting on the upper edge of a cylindrical retort shell which has welded around its upper margin a relatively short retort extension 28. The top of the retort is loosely covered with a plate 30 fitted with a vent pipe 31 and a set of nozzles 32 downwardly directed over each tube-receiving perforation in shelf 22. For decarburizing, the tubes are mounted as at 50 and wet hydrogen introduced through nozzles 32 so as to pass downwardly through and decarburize the interiors of the tubes. Some of the introduced hydrogen also spills over the flared tube ends and decarburizes them as well.

When the decarburizing is completed the flow of wet hydrogen is stopped, and gas chromizing streams are introduced through nozzles 32. No other change except for a shift to the chromizing temperature is needed, so that the retort can be kept at operating temperatures throughout.

The next shift is to aluminizing and for this the cover 30 or the nozzles 32 are removed so that a powder aluminizing pack can be poured into the tubes. By keeping the lower ends of the tubes within an inch (2.5 cm) or so of the retort floor a low fluency pack can be poured in place without building up very much on that floor. On the other hand a more fluent pack can be used with more of the pack spreading out on the floor as well as over the flared tube ends.

It will generally be desirable to cool the retort and its contents somewhat before introducing the aluminizing pack. To this end the burners around the retort can be shut down and a rapid flow of argon introduced through vent 31. Because no thermal insulation is present in the retort, aside from the masking layers, the tubes are fairly rapidly cooled in this way. After sufficient argon flow to flush and fill the retort with that gas, the retort cover or nozzles 32 can generally be removed even though the tubes are still at about 900°F (482°C), especially if the rapid argon flow is maintained as a protective shield around the tubes and the openings at the retort top kept very small. The aluminizing pack can then be promptly poured through such openings into the tubes to further cool them both by contact as well as volatilization of the activator contained in the pack. To avoid premature depletion of the activator when so added, the activator content of the pack can be somewhat elevated, such as 1 1/2% by weight, instead of the usual 1/4 to 1/2% by weight.

As soon as the pack addition is completed the retort-heating burners can be re-started to carry the retort contents to the desired alumizing temperature. Where the aluminizing pack is a chromium-free pack, the aluminizing can be very effectively conducted at temperatures as low as 1400°F (760°C) or even lower, without much reduction in coating rate. Aluminizing at temperatures below about 1200°F (649°C) is best effected with an aluminum halide activator such as $AlCl_3$.

The cooling applied before the aluminizing can be to very low temperatures if desired. Thus cooling to about 630°F (332°C) will enable the introduction of an $NH_4Cl$-activated pack without significant loss of $NH_4Cl$ by volatilization, and cooling to about 350°F (177°C) will similarly minimize loss of $AlCl_3$ from an $AlCl_3$-activated pack. Cooling to 150°F (66°C) will enable withdrawal of the chromized tubes from the retort, as for example if they are to be closely inspected to check on the chromized case or to replace the masking. Cut off short pieces of tubing can be placed on shelf 22 to act as test members that can be removed when desired to check on the treatment without removing the tubes themselves.

The consolidating of the aluminizing with the previous treatments requires much more than the mere consolidation of the decarburizing with the chromizing. This simpler consolidation can also be effected with the use of a chromizing path rather than a gas phase chromizing, so that such pack is replaced by an aluminizing pack for the aluminizing step.

The exteriors of the tubes subjected to the three-step treatment of decarburizing, chromizing and aluminizing, also show the effects of such treatment steps, although these effects are minimized at the masked areas. The decarburizing of the exteriors reduces the tube strengths, but this effect is insignificant when the tube wall thicknesses are greater than 1/8 inch (3.2 mm). Also such decarburized exteriors become chromized to some degree and this strengthens those surfaces.

Other chromium steels and other low alloy steels can be treated in place of the foregoing tubes, to give similarly protected products. Plain steels having about 0.1% or less of carbon are generally not strong enough or sufficiently resistant for use in hot environments, but they too can be similarly chromized and aluminized to yield products showing very little corrosion in hot sulfidation environments, and do not need a preliminary decarburizing. Steels that have their carbon contents stabilized as noted in U.S. Patent 3,449,159, likewise need no decarburizing.

A high degree of decarburizing is desirable for unstabilized carbon contents, inasmuch as this enables very heavy diffusion chromizing. The following is an exemplification.

Example II

The procedure of Example I is followed, with the following changes:

A. The decarburizing is conducted at 1825 to 1875°F (996—1024°C) for six hours with wet hydrogen having a dew point at least as high as 20°F (−7°C) to yield a decarburized surface 8 to 10 mils (203—254 μm) deep.

B. The chromizing is conducted with a non-prefired pack of 20% chromium and 80% non-fluent alumina, activated as in Example I. The chromizing is at 2050 to 2100°F (1121—1149°C) for 10 hours, leaving a chromized case 11 to 12 mils (279—305 μm) deep essentially all columnar ferrite and with little or no distinguishable chromium-carbide-rich phase. It is noted that the chromizing causes a little increase in the decarburizing depth, and is as deep as the resulting decarburizing. The surface chromium content is about 50 milligrams per square centimeter. The chromizing also causes significant loss of carbon from the body of the substrate.

C. The aluminizing is conducted with a non-prefired pack of, by weight:

                5.4%    aluminum
               46.4%    chromium
             balance    alumina

activated as in Example I. The aluminizing temperature is 2050 to 2100°F (1121—1149°C) for 10 hours. The resulting case is about 20 mils (508 μm) deep and the aluminum concentration at the surface is about 12%.

Modifying Example II by reducing the aluminum content of the aluminizing pack to 2.5% and its chromium to 43.5% yields a case depth of about 18 mils (457 μm) and a surface aluminum content of about 6%.

The products of Example II shows a somewhat better resistance than that of Example I, to oxidative attack by air at 1500°F (816°C).

The masking compositions used in the process of the present invention are preferably free of metallic aluminum or metallic aluminides. Alumina alone is an effective maskant for the techniques of the examples, inasmuch as the masking is not in a location contacted by a diffusion coating pack.

On ordinary irons and steels as well as low alloy steels, a localized layer of powdered iron appropriately diluted with inert diluent such as alumina, can be applied to reduce or prevent diffusion coating under the layer. This layer can be covered by a sheath-forming layer, but such covering is not needed where the workpieces are not roughly handled during treatment.

Powdered iron containing chromium can also be used, suitably diluted, particularly to mask chromium steels against aluminizing. Nickel can also be present in such a masking powder, even though it tends to diffuse into the masked surface. It is generally more important to keep aluminum from diffusing into the surfaces to be masked, inasmuch as the aluminizing is so aggressive and leaves a surface difficult to weld. It takes at least about 20% diluent powder of non-metallic masking composition to the point that it does not sinter to the workpiece.

Where the presence of a little aluminum can be tolerated, the masking compositions of U.S. Patent 4,208,453 can be used.

Obviously many modifications and variations of the present invention are possible in the light of the above teachings. It is therefore to be understood that within the scope of the appended claims the invention may be practiced otherwise than as specifically described.

**Claims**

1. A process for increasing the resistance to hot sulfidation of a low alloy steel member which process is characterised by:

(a) if the steel contains about 0.1% or more of carbon which has not been stabilised, decarburising to a depth of substantially 3 mils (76.2 μm) or more the surface of the member exposed to the attack,

(b) diffusion chromizing said surface to produce a chromized case substantially 2 mils (50.8 μm) or more thick, the inner portion of which has a columnar ferrite structure, and

(c) diffusion aluminizing the chromized case to provide a final diffusion case substantially 10 mils (254 μm) or more thick and thicker than the chromized case.

2. A process as claimed in claim 1 wherein the decarburizing is not carried out and the steel contains less than 0.1% by weight of carbon or the carbon therein is stabilised.

3. A process as claimed in claim 1 in which the decarburizing is carried out.

4. A process as claimed in claim 3 in which the steel is a chromium steel containing carbon in an unstabilized condition.

5. A process as claimed in any one of the preceding claims in which the equipment is a tube and the diffusion coating is applied essentially only to the surface of the tube exposed to the attack.

6. A process as claimed in claim 5 in which mounting portions on the external surface of the tube are masked to minimize diffusion coating in those locations.

7. A process as claimed in claim 5 in which the diffusion coating is effected with a coating pack in contact with said tube surface, and the adjacent surfaces of the tube are covered by inert maskant to keep them from receiving a coating.

8. A process as claimed in claim 7, in which the maskant is alumina.

9. A process as claimed in any one of the preceding claims, in which the chromizing is sufficiently heavy to leave the aluminized surface with a chromium content of substantially 15% by weight or more.

10. A process as claimed in any one of the preceding claims in which the aluminizing is arranged to result in a surface aluminum content of about 12% by weight or less.

11. A process as claimed in claim 10 in which the surface aluminum content is about 6% by weight or less.

12. A process as claimed in claim 10 or claim 11 in which the low alloy steel is a chromium steel.

13. A process as claimed in any one of claims 1 to 5 in which the aluminizing is arranged to reduce the relative surface aluminum content in the region of the welding sites.

14. A process as claimed in any one of claims 1 to 5 in which the mounting sites are covered by a covering layer during the aluminizing.

15. A process as claimed in claim 14 in which the covering layer is a layer that is essentially inert to the aluminizing.

16. A process as claimed in claim 14 in which the covering layer is a masking layer that essentially prevents aluminizing through that layer.

17. A low alloy steel member having a surface portion decarburized, if the steel contains about 0.1% or more of carbon which has not been stabilised, to a depth of substantially 3 mils (76.2 μm) or more, chromized to a depth of substantially 2 mils (50.8 μm) or more to form a chromised case whose inner portion has a columnar ferrite structure and then aluminized to a depth of at least 10 mils (254 μm) and greater than the chromized depth.

18. A steel member as claimed in claim 17 which is not decarburized and contains less than 0.1% by weight of carbon or in which the carbon is stabilised.

19. A steel member as claimed in claim 17 or claim 18 which is at least partially exposed to hot sulfur-containing petroleum residues and said surface portion is the portion of the surface of the steel member exposed to the petroleum residues.

20. A steel member as claimed in any one of claims 17 to 19 which is a low alloy chromium steel member.

**Patentansprüche**

1. Verfahren zur Steigerung des Widerstandes eines niedriglegierten Stahlbauteiles gegenüber einer heißen Sulfidierung, welches Verfahren gekennzeichnet ist durch:

(a) Entkohlung der dem Angriff ausgesetzten Oberfläche des Bauteiles auf eine Tiefe von im wesentlichen 76,2 μm (3 mils) oder mehr, wenn der Stahl etwa 0,1% oder mehr Kohlenstoff, der nicht stabilisiert wurde, enthält,

(b) Diffusionsverchromung dieser Oberfläche zur Herstellung einer verchromten Oberflächenschicht einer Dicke von im wesentlichen 50,8 μm (2 mils) oder mehr, deren innerer Teil eine stengelige Ferritstruktur aufweist, und

(c) Diffusionsveraluminierung der verchromten Oberflächenschicht zur Bereitstellung einer endgültigen Diffusionsoberflächenschicht einer Dicke von im wesentlichen 254 μm (10 mils) oder mehr, die dicker als die verchromte Oberflächenschicht ist.

2. Verfahren wie in Anspruch 1 beansprucht, worin die Entkohlung nicht durchgeführt wird und der Stahl weniger als 0,1 Gew.-% Kohlenstoff enthält oder der Kohlenstoff darin stabilisiert ist.

3. Verfahren wie in Anspruch 1 beansprucht, worin die Entkohlung durchgeführt wird.

4. Verfahren wie in Anspruch 3 beansprucht, worin der Stahl ein Chromstahl ist, der Kohlenstoff in einem nicht stabilisierten Zustand enthält.

5. Verfahren wie in einem der vorhergehenden Ansprüche beansprucht, worin die Einrichtung ein Rohr ist und die Diffusionsbeschichtung im wesentlichen nur auf die dem Angriff ausgesetzte Oberfläche des Rohres aufgebracht wird.

6. Verfahren wie in Anspruch 5 beansprucht, worin Befestigungsteile an der äußeren Oberfläche des Rohres maskiert werden, um eine Diffusionsbeschichtung an diesen Stellen zu minimieren.

7. Verfahren wie in Anspruch 5 beansprucht, worin die Diffusionsbeschichtung mit einer Beschichtungspackung in Berührung mit der Oberfläche des Rohres bewirkt wird und die benachbarten Oberflächen des Rohres mit einem inerten Abdeckmaterial bedeckt werden, um sie von einer Beschichtung freizuhalten.

8. Verfahren wie in Anspruch 7 beansprucht, worin das Abdeckmaterial Tonerde ist.

9. Verfahren wie in einem der vorstehenden Ansprüche beansprucht, worin die Verchromung ausreichend stark ist, um in der veraluminierten Oberfläche einen Chromgehalt von im wesentlichen 15 Gew.-% oder mehr zu erhalten.

10. Verfahren wie in einem der vorstehenden Ansprüche beansprucht, worin die Veraluminierung so eingerichtet wird, daß ein Aluminiumgehalt der Oberfläche von etwa 12 Gew.-% oder weniger erhalten wird.

11. Verfahren wie in Anspruch 10 beansprucht, worin der Aluminiumgehalt der Oberfläche etwa 6 Gew.-% oder weniger beträgt.

12. Verfahren wie in Anspruch 10 oder Anspruch 11 beansprucht, worin der niedriglegierte Stahl ein Chromstahl ist.

13. Verfahren wie in einem der Ansprüche 1 bis 5 beansprucht, worin die Veraluminierung so eingerichtet wird, daß der relative Aluminiumgehalt der Oberfläche im Bereich der Schweißstellen verringert wird.

14. Verfahren wie in einem der Ansprüche 1 bis 5 beansprucht, worin die Befestigungsstellen während der Veraluminierung durch eine Deckschicht bedeckt werden.

15. Verfahren wie in Anspruch 14 beansprucht, worin die Deckschicht eine Schicht ist, welche gegenüber der Veraluminierung im wesentlichen inert ist.

16. Verfahren wie in Anspruch 14 beansprucht, worin die Deckschicht eine Maskierungsschicht ist, welche die Veraluminierung durch diese Schicht im wesentlichen verhindert.

17. Niedriglegiertes Stahlbauteil, welches eine Oberflächenteil aufweist, der auf eine Tiefe von im wesentlichen 76,2 μm (3 mils) oder mehr entkohlt wurde, wenn der Stahl etwa 0,1% oder mehr Kohlenstoff, der nicht stabilisier wurde, enthält, auf eine Tiefe von im wesentlichen 50,8 μm (2 mils) oder mehr verchromt wurde unter Bildung einer verchromten Oberflächenschicht, deren innerer Teil eine Stengelige Ferritstruktur aufweist und dann auf eine Tiefe von mindestens 245 μm (10 mils), die größer als die verchromte Tiefe ist, veraluminiert wurde.

18. Stahlbauteil wie in Anspruch 17 beansprucht, welches nicht entkohlt ist und weniger als 0,1 Gew.-% Kohlenstoff enthält oder in welchem der Kohlenstoff stabilisiert ist.

19. Stahlbauteil wie in Anspruch 17 oder Anspruch 18 beansprucht, welches mindestens teilweise heßen schwefelhaltigen Erdölrückständen ausgesetzt ist, und worin der genannte Oberflächenteil der Teil der Oberfläche des Stahlbauteiles ist, welcher den Erdölrückständen ausgesetzt ist.

20. Stahlbauteil wie in einem der Ansprüche 17 bis 19 beansprucht, welches ein niedriglegiertes Chromstahlbauteil ist.

**Revendications**

1. Procédé pour accroître la résistance à la sulfuration à chaud d'un élément en acier allié à faible teneur, procédé qui est caractérisé par:

(a) si l'acier contient environ 0,1% ou plus de carbone qui n'a pas été stabilisé, la décarburation à une profondeur pratiquement égale ou supérieure à 3 mils (76,2 μm) de la surface de l'élément exposé à l'attaque,

(b) la chromisation par diffusion de ladite surface pour produire une couche superficielle cémentée par le chrome ayant une épaisseur pratiquement égale ou supérieure à 2 mils (50,8 μm), dont la portion interne possède une structure de ferrite basaltique, et

(c) une alumination par diffusion de la couche superficielle cémentée par le chrome pour obtenir une couche superficielle finale cémentée par diffusion ayant une épaisseur pratiquement égale ou supérieure à 10 mils (254 μm), épaisseur supérieure à celle de la couche superficielle cémentée par le chrome.

2. Procédé suivant la revendication 1, dans lequel la décarburation n'est pas effectuée et l'acier contient moins de 0,1% en poids de carbone ou bien dans lequel le carbone présent est stabilisé.

3. Procédé suivant la revendication 1, dans lequel la décarburation est effectuée.

4. Procédé suivant la revendication 3, dans lequel l'acier est un acier au chrome contenant du carbone à l'état non stabilisé.

5. Procédé suivant l'une quelconque des revendications précédentes, dans lequel l'appareillage est un tube et le revêtement par diffusion est appliqué pratiquement seulement sur la surface du tube exposée à l'attaque.

6. Procédé suivant la revendication 5, dans lequel les pièces nécessaires an montage sur la surface externe du tube sont masquées pour réduire au minimum le revêtement par diffusion à ces emplacements.

7. Procédé suivant la revendication 5, dans lequel le revêtement par diffusion est effectué avec une masse de revêtement en contact avec la surface du tube, et les surfaces adjacentes du tube sont recouvertes d'un agent de masquage inerte destiné à les empêcher de recevoir un revêtement.

8. Procédé suivant la revendication 7, dans lequel l'agent de masquage est l'alumine.

9. Procédé suivant l'une quelconque des revendications précédentes, dans lequel la chromisation est suffissamment épaisse pour laisser la surface aluminée avec une teneur en chrome égale ou supérieure à environ 15% en poids.

10. Procédé suivant l'une quelconque des revendications précédentes, dans lequel l'alumination est fixée de manière à avoir pour résultat une teneur en aluminium en surface égale ou inférieure à environ 12% en poids.

11. Procédé suivant la revendication 10, dans lequel la teneur en aluminium en surface est égale ou inférieure à environ 6% en poids.

12. Procédé suivant la revendication 10 ou la revendication 11, dans lequel l'acier allié à faible teneur est un acier en chrome.

13. Procédé suivant l'une quelconque des revendications 1 à 5, dans lequel l'alumination est fixée de manière à réduire la teneur relative en aluminium en surface dans la région des sites de soudage.

14. Procédé suivant l'une quelconque des revendications 1 à 5, dans lequel les sites de montage sont recouverts par une couche protectrice au cours de l'alumination.

15. Procédé suivant la revendication 14, dans lequel la couche protectrice est une couche qui est pratiquement inerte vis-à-vis de l'alumination.

16. Procédé suivant la revendication 14, dans lequel la couche protectrice est une couche de masquage qui évite pratiquement l'alumination à travers cette couche.

17. Elément en acier allié à faible teneur ayant une partie de sa surface décarburée, si l'acier contient environ 0,1% ou plus de carbone qui n'a pas été stabilisé, à une profondeur pratiquement égale ou supérieure à 3 mils (76,2 µm), cémentée par le chrome à une profondeur pratiquement égale ou supérieure à 2 mils (50,8 µm) pour former une couche supercifielle cémentée par le chrome dont la portion interne possède une structure de ferrite basaltique, puis aluminée à une profondeur d'au moins 10 mils (254 µm) et supérieure à la profondeur cémentée par le chrome.

18. Elément en acier suivant la revendication 17, qui n'est pas décarburé et contient moins de 0,1% en poids de carbone, ou bien dans lequel le carbone est stabilisé.

19. Elément en acier suivant la revendication 17 ou la revendication 18, qui est au moins partiellement mis en contact avec des résidus chauds de pétrole contenant du soufre, la portion de surface étant la portion de la surface de l'élément en acier mise en contact avec les résidus de pétrole.

20. Elément en acier suivant l'une quelconque des revendications 17 à 19, qui est un élément en acier au chrome allié à faible teneur.

Fig.1.

Fig.2.